# EUROPEAN PATENT APPLICATION

(11) **EP 4 696 645 A1**
(43) Date of publication of application: **18.02.2026**
(21) Application number: 24848744.9
(22) Date of filing: 25.06.2024
(51) Int. Cl.: B81B 3/00, B81C 1/00, H10D 48/50

(54) **MEMS DEVICE AND METHOD FOR MANUFACTURING MEMS DEVICE**

(30) Priority: 01.08.2023 JP 2023125301
(71) Applicant: Murata Manufacturing Co., Ltd., Nagaokakyo-shi, Kyoto 617-8555 (JP)
(72) Inventor: FUKUMITSU, Masakazu, Nagaokakyo-shi, Kyoto 617-8555 (JP); TORKKELI, Altti, Nagaokakyo-shi, Kyoto 617-8555 (JP); RYTKONEN, Ville-Pekka, Nagaokakyo-shi, Kyoto 617-8555 (JP); BLOMQVIST, Anssi, Nagaokakyo-shi, Kyoto 617-8555 (JP); LIUKKU, Matti, Nagaokakyo-shi, Kyoto 617-8555 (JP); OKAWA, Tadayuki, Nagaokakyo-shi, Kyoto 617-8555 (JP); KILPINEN, Petteri, Nagaokakyo-shi, Kyoto 617-8555 (JP)
(74) Representative: Stöckeler, Ferdinand
(86) International application number: PCT/JP2024/023057
(87) International publication number: WO 2025/028084

(57) **Abstract**

A MEMS device (1) includes a lower cover (10), an upper cover (30) that forms a space between the upper cover (30) and the lower cover (10), a first substrate (20A) that is disposed opposite to the lower cover (10) in the space formed between the upper cover (30) and the lower cover (10) and is composed of single-crystal silicon, a second substrate (20B) that is disposed opposite to the upper cover (30) in the space formed between the upper cover (30) and the lower cover (10) and is composed of single-crystal silicon. The second substrate (20B) includes a movable portion (24B). The single-crystal silicon of the second substrate (20B) is joined to the single-crystal silicon of the first substrate (20A). The MEMS device (1) includes also an electrostatic capacity portion that is made at least one of between the upper cover (30) and the second substrate (20B) or between the first substrate (20A) and the second substrate (20B) and is configured such that electrostatic capacity changes depending on the distance between the movable portion (24B) and the upper cover (30) or the first substrate (20A).

## Description

### Technical Field

The present invention relates to a MEMS device and a manufacturing method for a MEMS device.

### Background Art

Hitherto, a device manufactured by using a Micro Electro Mechanical Systems (MEMS) technology is popular. This device is formed by, for example, joining an upper-side substrate to a lower-side substrate having an element.

For example, in Patent Document 1, a first movable electrode and a second movable electrode are separated from a holding portion by a spring portion. By this configuration, even when deformation occurs in an upper cover due to application of a force or the like attributed to a pressure from the external or a thermal expansion difference, a change in the inter-electrode distance between the first movable electrode and the second movable electrode due to the deformation of the upper cover is reduced, and the lowering of the detection accuracy of an electrostatic capacity value in an electrostatic capacity portion is suppressed.

### Citation List

### Patent Document

Patent Document 1: International Publication No. 2023/032304

### Summary of Invention

### Technical Problem

However, in an invention described in Patent Document 1, a silicon oxide layer is laminated on a Si substrate at the electrostatic capacity portion. Thus, a via electrode is required to be disposed in order to electrically connect the Si substrate at the electrostatic capacity portion to a Si film, and size reduction of the MEMS device is difficult because of ensuring of a disposing space for the via electrode. Further, side etching is required to be executed for the silicon oxide layer laminated on the Si substrate in order to ensure the movable range of the first movable electrode and the second movable electrode, and the area of the silicon oxide layer is required to be sufficiently ensured in advance in consideration of the area cut in the side etching. Thus, size reduction of the MEMS device is difficult also in terms of this point.

The present invention has been made in view of such circumstances, and intends to provide a MEMS device and a manufacturing method for a MEMS device that enable size reduction.

### Solution to Problem

A MEMS device according to an aspect of the present invention includes a lower cover, an upper cover that forms a space between the upper cover and the lower cover, a first substrate that is disposed opposite to the lower cover in the space formed between the upper cover and the lower cover and is composed of single-crystal silicon, and a second substrate that is disposed opposite to the upper cover in the space formed between the upper cover and the lower cover and is composed of single-crystal silicon. The second substrate includes a movable portion. The single-crystal silicon of the second substrate is joined to the single-crystal silicon of the first substrate. The MEMS device includes also an electrostatic capacity portion that is made at least one of between the upper cover and the second substrate or between the first substrate and the second substrate and is configured such that electrostatic capacity changes depending on a distance between the movable portion and the upper cover or the first substrate.

A manufacturing method for a MEMS device according to an aspect of the present invention includes a step of disposing a first substrate composed of single-crystal silicon opposite to a lower cover, a step of disposing a second substrate that is composed of single-crystal silicon and includes a movable portion opposite to an upper cover and joining the single-crystal silicon of the second substrate to the single-crystal silicon of the first substrate, a step of disposing the first substrate and the second substrate in a space surrounded by the upper cover and the lower cover, and a step of making an electrostatic capacity portion at least one of between the upper cover and the second substrate or between the first substrate and the second substrate. The electrostatic capacity portion is configured such that electrostatic capacity changes depending on a distance between the movable portion and the upper cover or the first substrate.

### Advantageous Effects of Invention

According to the present invention, size reduction is enabled.

### Brief Description of Drawings

[Fig. 1] Fig. 1 is a perspective view schematically depicting appearance of a MEMS device.

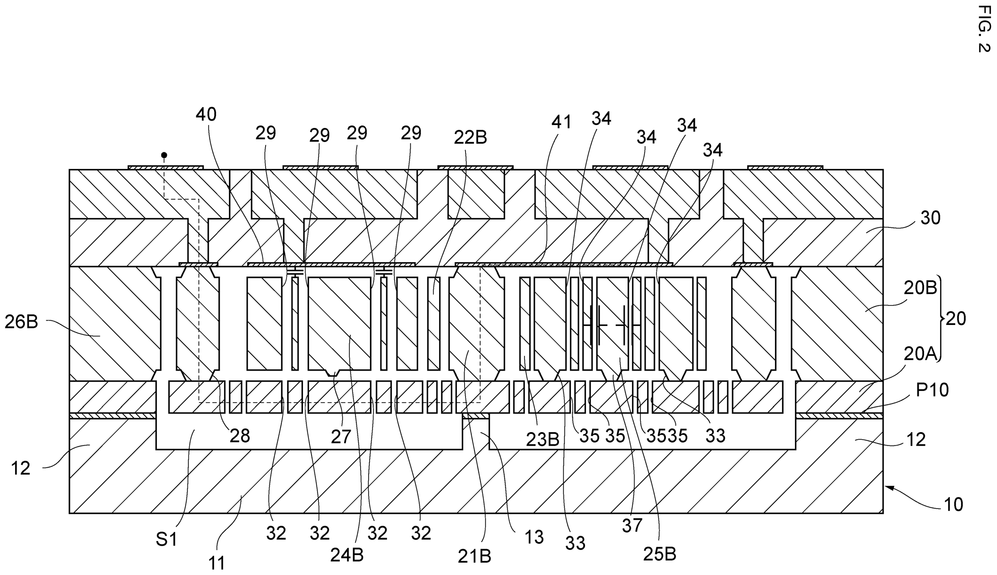

[Fig. 2] Fig. 2 is a sectional view of the MEMS device.

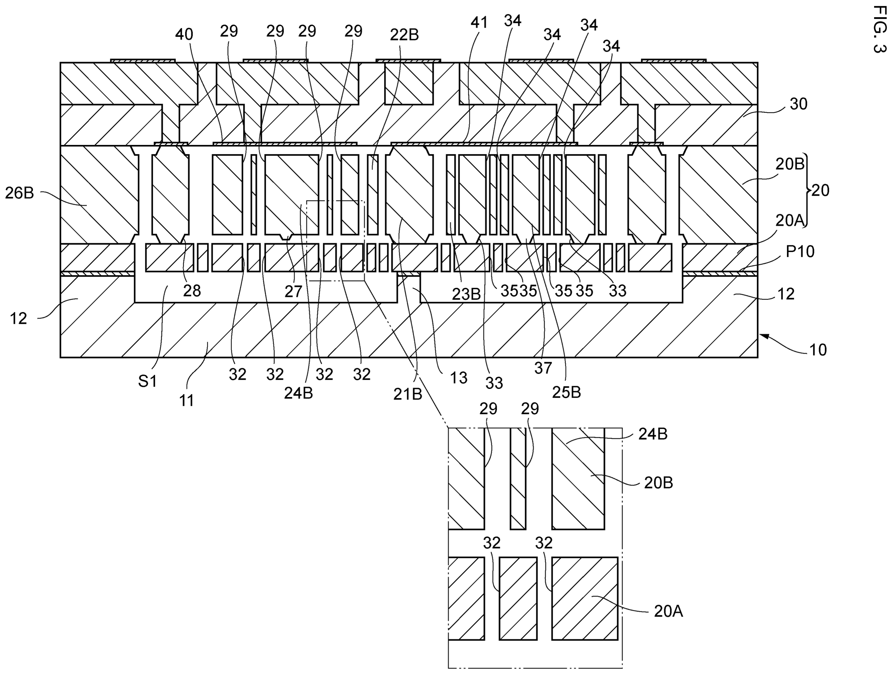

[Fig. 3] Fig. 3 is an enlarged sectional view of a major part of the MEMS device.
[Fig. 4A] Fig. 4A is a schematic diagram for explaining an example of a manufacturing method for the MEMS device.
[Fig. 4B] Fig. 4B is a schematic diagram for explaining the example of the manufacturing method for the MEMS device.
[Fig. 4C] Fig. 4C is a schematic diagram for explaining the example of the manufacturing method for the MEMS device.
[Fig. 4D] Fig. 4D is a schematic diagram for explaining the example of the manufacturing method for the MEMS device.
[Fig. 4E] Fig. 4E is a schematic diagram for explaining the example of the manufacturing method for the MEMS device.
[Fig. 4F] Fig. 4F is a schematic diagram for explaining the example of the manufacturing method for the MEMS device.
[Fig. 5A] Fig. 5A is a schematic diagram for explaining another example of the manufacturing method for the MEMS device.
[Fig. 5B] Fig. 5B is a schematic diagram for explaining the other example of the manufacturing method for the MEMS device.
[Fig. 5C] Fig. 5C is a schematic diagram for explaining the other example of the manufacturing method for the MEMS device.
[Fig. 5D] Fig. 5D is a schematic diagram for explaining the other example of the manufacturing method for the MEMS device.
[Fig. 5E] Fig. 5E is a schematic diagram for explaining the other example of the manufacturing method for the MEMS device.
[Fig. 6A] Fig. 6A is a schematic diagram for explaining a further example of the manufacturing method for the MEMS device.
[Fig. 6B] Fig. 6B is a schematic diagram for explaining the further example of the manufacturing method for the MEMS device.
[Fig. 6C] Fig. 6C is a schematic diagram for explaining the further example of the manufacturing method for the MEMS device.
[Fig. 6D] Fig. 6D is a schematic diagram for explaining the further example of the manufacturing method for the MEMS device.
[Fig. 6E] Fig. 6E is a schematic diagram for explaining the further example of the manufacturing method for the MEMS device.
[Fig. 6F] Fig. 6F is a schematic diagram for explaining the further example of the manufacturing method for the MEMS device.
[Fig. 6G] Fig. 6G is a schematic diagram for explaining the further example of the manufacturing method for the MEMS device.
[Fig. 6H] Fig. 6H is a schematic diagram for explaining the further example of the manufacturing method for the MEMS device.

### Description of Embodiments

An embodiment of the present invention is described below. In depiction of the following drawings, the same or similar constituent element is represented by the same or similar numeral. The drawings are given as examples, and the dimensions and the shape of each part are schematic. The technical scope of the present invention should not be interpreted as a scope limited to this embodiment.

A MEMS device 1 according to the present embodiment is described with reference to the drawings.

In the following description, the respective drawings are sometimes given a Cartesian coordinate system composed of an X-axis, a Y-axis, and a Z-axis for convenience in order to clarify the mutual relationship among the respective drawings and facilitate understanding of the positional relationship among the respective members. Directions parallel to the X-axis, the Y-axis, and the Z-axis are defined as an X-axis direction, a Y-axis direction, and a Z-axis direction, respectively. A plane defined by the X-axis and the Y-axis is defined as an XY-plane. For convenience, the description is given such that the Z-axis positive direction side (direction of an arrow) is defined as the top side or the upper side and the Z-axis negative direction side (opposite direction to the arrow) is defined as the bottom side or the lower side. However, the orientation of the MEMS device 1 is not limited thereto.

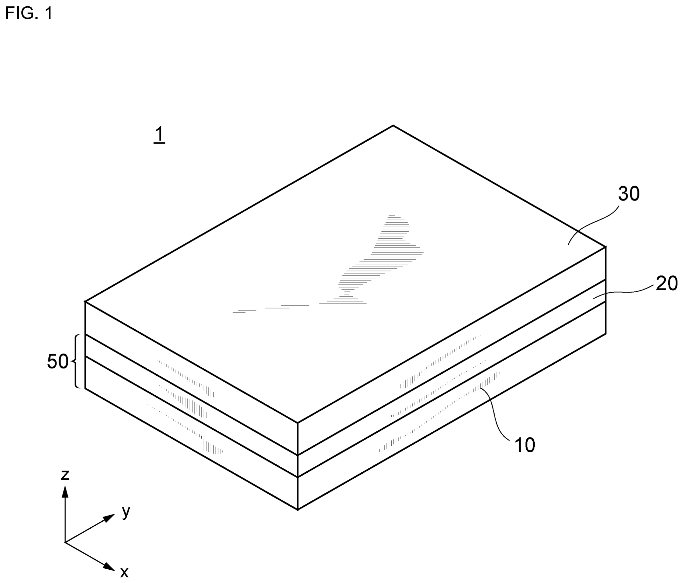

As depicted in Fig. 1, the MEMS device 1 is a device manufactured by using a MEMS technology, and is, for example, a device for detecting the acceleration in each of the X-axis direction, the Y-axis direction, and the Z-axis direction. The MEMS device 1 includes a lower cover 10, a device layer 20, and an upper cover 30. The lower cover 10, the device layer 20, and the upper cover 30 are laminated in that order in the Z-axis direction. Hereinafter, the direction in which the lower cover 10, the device layer 20, and the upper cover 30 are laminated is defined as "thickness direction." The device layer 20 and the lower cover 10 are joined to form a MEMS substrate 50. The upper cover 30 is joined to the device layer 20 of the MEMS substrate 50. In other words, the upper cover 30 is joined to the lower cover 10, with the device layer 20 interposed therebetween. The lower cover 10 and the upper cover 30 are opposite to each other across the device layer 20 in the thickness direction. The lower cover 10 and the upper cover 30 form a package structure internally forming a vibration space in which the device layer 20 vibrates.

The lower cover 10 has a bottom plate 11, a sidewall 12, and a fixing portion 13. The bottom plate 11 has a plate shape, and extends in a plane along the X-axis direction and the Y-axis direction. The sidewall 12 extends from a rim portion of the bottom plate 11 toward the upper cover 30. A silicon oxide film P10 is made on a tip portion of the sidewall 12. The sidewall 12 is joined to the device layer 20, with the silicon oxide film P10 interposed therebetween. The fixing portion 13 extends from the bottom plate 11 toward the device layer 20. The silicon oxide film P10 is made on a tip portion of the fixing portion 13. The fixing portion 13 is joined to the device layer 20, with the silicon oxide film P10 interposed therebetween.

The device layer 20 includes a first substrate 20A and a second substrate 20B.

The first substrate 20A is composed of single-crystal silicon. The first substrate 20A is formed of, for example, a p-type silicon (Si) semiconductor. The first substrate 20A can contain boron (B) or the like as a p-type dopant. The first substrate 20A is joined to the sidewall 12 and the fixing portion 13 of the lower cover 10, with the silicon oxide film P10 interposed therebetween. The first substrate 20A closes an opening of a space S1 surrounded by the bottom plate 11 and the sidewall 12 in the lower cover 10. The first substrate 20A includes a plurality of slits penetrating the first substrate 20A in the thickness direction.

The second substrate 20B is composed of single-crystal silicon. The second substrate 20B is formed of, for example, a p-type silicon (Si) semiconductor. The second substrate 20B can contain boron (B) or the like as a p-type dopant. The single-crystal silicon of the second substrate 20B is joined to the single-crystal silicon of the first substrate 20A. That is, the second substrate 20B is directly bonded to the first substrate 20A. The thickness of the second substrate 20B is thicker than that of the first substrate 20A.

The second substrate 20B includes a support portion 21B, spring portions 22B and 23B, movable portions 24B and 25B, and a peripheral portion 26B. The support portion 21B, the spring portions 22B and 23B, the movable portions 24B and 25B, and the peripheral portion 26B are formed by executing pattering based on removal processing for the second substrate 20B. The removal processing is executed by, for example, dry etching referred to as deep reactive ion etch (DRIE). The removal processing may be executed by other methods such as wet etching and laser etching.

The support portion 21B is joined to the fixing portion 13 of the lower cover 10, with the first substrate 20A interposed therebetween. The support portion 21B supports the movable portions 24B and 25B movably in the Z-axis direction, with the spring portions 22B and 23B interposed therebetween.

The spring portions 22B and 23B include a plurality of slits penetrating the second substrate 20B in the thickness direction, and are configured to be elastically deformable in the Z-axis direction.

The movable portion 24B is configured to be movable in the Z-axis direction. The movable portion 24B corresponds to an electrode. An electrostatic capacity portion is made between the movable portion 24B and the upper cover 30 and between the movable portion 24B and the first substrate 20A.

A surface opposite to the first substrate 20A in the movable portion 24B is provided with a protruding portion 27. The protruding portion 27 is disposed at the center of the movable portion 24B in the Y-axis direction. The protrusion amount of the protruding portion 27 is smaller than the interval between the movable portion 24B and the first substrate 20A. The protruding portion 27 is formed by the local-oxidation-of-silicon (LOCOS) method. The LOCOS method is a method in which a silicon substrate other than a part masked by a nitride film is oxidized to form a region (active region) electrically insulated from the surroundings by a layer of this oxide film.

A recessed portion 28 is made in the surface opposite to the first substrate 20A in the movable portion 24B. The recessed portion 28 has a reverse taper shape expanded outward, and is formed by the local-oxidation-of-silicon (LOCOS) method. A plurality of slits 29 linearly penetrating the movable portion 24B in the thickness direction are open in the bottom surface of the recessed portion 28. Further, a plurality of slits 32 linearly penetrating the first substrate 20A in the thickness direction are made at positions opposite to the recessed portion 28 of the movable portion 24B in the first substrate 20A. The slits 32 are open to a space surrounded by the recessed portion 28 of the movable portion 24B and the first substrate 20A.

When the MEMS device 1 receives an inertial force (for example, acceleration or angular velocity) or a pressure in the Z-axis direction, the movable portion 24B moves in the Z-axis direction, and electrostatic capacity formed between the recessed portion 28 of the movable portion 24B and the first substrate 20A changes on the basis of the distance between the recessed portion 28 of the movable portion 24B and the first substrate 20A.

The movable portion 25B includes a plurality of slits 29 penetrating the second substrate 20B in the thickness direction, and is configured to be movable in the X-axis direction and the Y-axis direction. The movable portion 25B corresponds to an electrode. An electrostatic capacity portion is made between parts opposite to each other in the X-axis direction and the Y-axis direction, with the above-described slit 29 interposed therebetween.

When the MEMS device 1 receives an inertial force (for example, acceleration or angular velocity) or a pressure in the X-axis direction or the Y-axis direction, the movable portion 25B moves in the X-axis direction or the Y-axis direction. Further, on the basis of the distance between parts opposite to each other in the X-axis direction and the Y-axis direction, electrostatic capacity formed between these parts changes.

A surface opposite to the first substrate 20A in the movable portion 25B is provided with a protruding portion 37. The protruding portion 37 is disposed at the center of the movable portion 25B in the Y-axis direction. The protrusion amount of the protruding portion 37 is smaller than the interval between the movable portion 25B and the first substrate 20A. The protruding portion 37 is formed by the local-oxidation-of-silicon (LOCOS) method.

Recessed portions 33 are made in the surface opposite to the first substrate 20A in the movable portion 25B. The recessed portions 33 are disposed to make a pair on both sides based on the protruding portion 27 in the Y-axis direction. Each of the pair of recessed portions 31 has a reverse taper shape expanded outward, and is formed by the local-oxidation-of-silicon (LOCOS) method. A plurality of slits 34 linearly penetrating the movable portion 25B in the thickness direction are open in the bottom surfaces of the recessed portions 33. Moreover, a plurality of slits 35 linearly penetrating the first substrate 20A in the thickness direction are made at positions opposite to the recessed portion 33 of the movable portion 25B in the first substrate 20A. The slits 35 are open to spaces surrounded by the recessed portion 33 of the movable portion 25B and the first substrate 20A.

The peripheral portion 26B is joined to the sidewall 12 of the lower cover 10, with the first substrate 20A interposed therebetween. The peripheral portion 26B has a frame body shape, and is configured to surround the movable portions 24B and 25B in plan view. The peripheral portion 26B is disposed at intervals from the movable portions 24B and 25B in the X-axis direction and the Y-axis direction.

The upper cover 30 is formed into a flat plate shape. The upper cover 30 is formed of, for example, a p-type silicon (Si) semiconductor. Electrodes 40 and 41 are disposed on the lower surface of the upper cover 30. The electrode 40 is disposed opposite to the movable portion 24B in the Z-axis direction, and the electrode 41 is disposed opposite to the movable portion 25B in the Z-axis direction. The electrodes 40 and 41 are formed of, for example, aluminum (Al), an aluminum-copper alloy (AlCu), titanium (Ti), a titanium-tungsten alloy (TiW), or the like. The electrode 40 is used for detection of electrostatic capacity formed with the movable portion 24B. The electrode 41 is used for detection of electrostatic capacity formed with the movable portion 25B.

Next, a description is given below of an example of a manufacturing method for the MEMS device 1, particularly of an example of a method for forming electrostatic capacity between the movable portion 24B and the first substrate 20A.

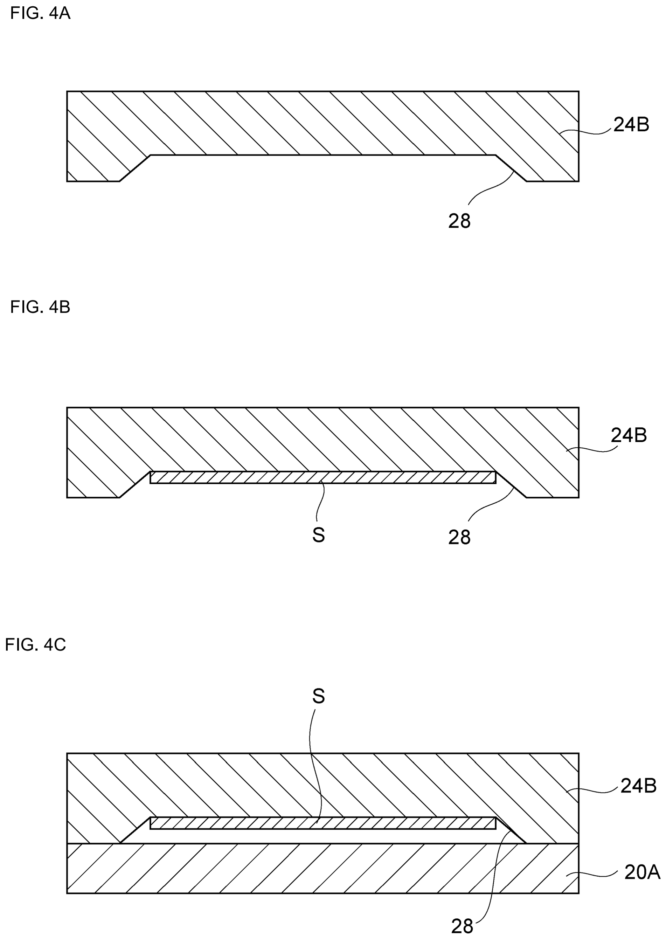

First, as depicted in Fig. 4A, the recessed portion 28 is formed by the LOCOS method in the surface opposite to the first substrate 20A in the movable portion 24B.

Next, as depicted in Fig. 4B, an etching stopper layer S formed of a silicon oxide film is formed on the bottom surface of the recessed portion 28 by sputtering, chemical vapor deposition (CVD), thermal oxidation, or the like.

Next, as depicted in Fig. 4C, the movable portion 24B on which the etching stopper layer S is formed and the first substrate 20A are joined by direct bonding.

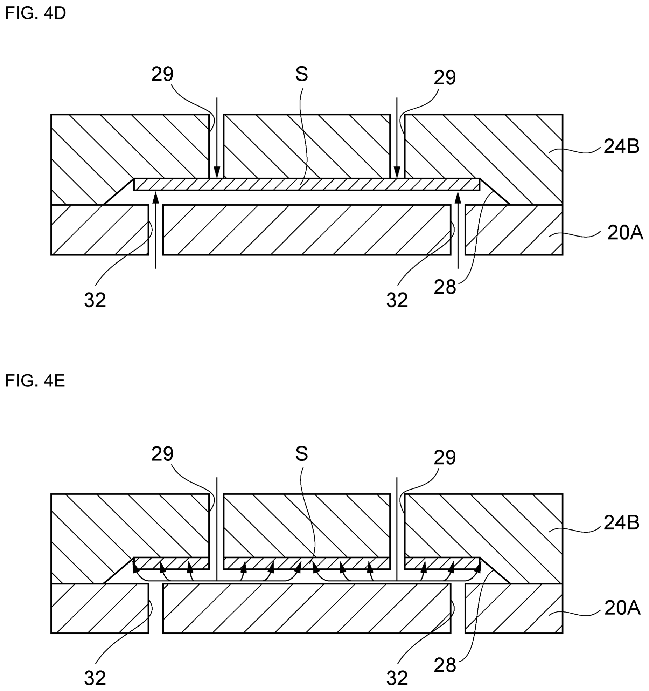

Next, as depicted in Fig. 4D, the movable portion 24B and the first substrate 20A are etched by reactive ion etching (RIE) to positions at which the etching stopper layer S is formed, and the slits 29 penetrating the movable portion 24B in the thickness direction and the slits 32 penetrating the first substrate 20A in the thickness direction are formed.

Next, as depicted in Fig. 4E, a vapor-phase hydrofluoric acid gas is supplied to a space formed between the recessed portion 28 of the movable portion 24B and the first substrate 20A through the slits 29 and 32 formed previously, and the etching stopper layer S is removed.

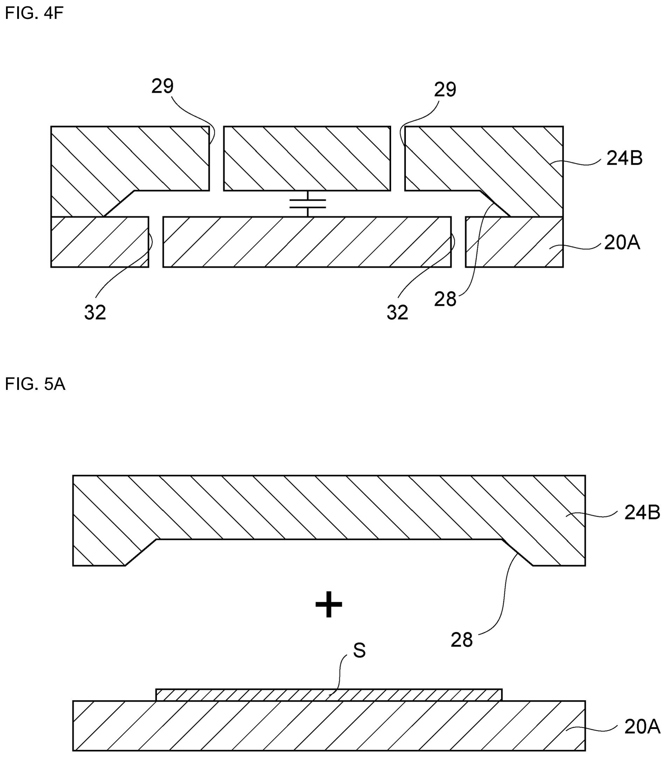

Through this process, as depicted in Fig. 4F, an electrostatic capacity portion with electrostatic capacity that changes depending on the distance between the movable portion 24B and the first substrate 20A is formed in the space between the movable portion 24B and the first substrate 20A.

Next, a description is given below of another example of the manufacturing method for the MEMS device 1, particularly of another example of the method for forming electrostatic capacity between the movable portion 24B and the first substrate 20A.

First, as depicted in Fig. 5A, the recessed portion 28 is formed by the LOCOS method in the surface opposite to the first substrate 20A in the movable portion 24B. Further, the etching stopper layer S formed of a silicon oxide film is formed on the surface opposite to the movable portion 24B in the first substrate 20A by sputtering, chemical vapor deposition (CVD), thermal oxidation, or the like.

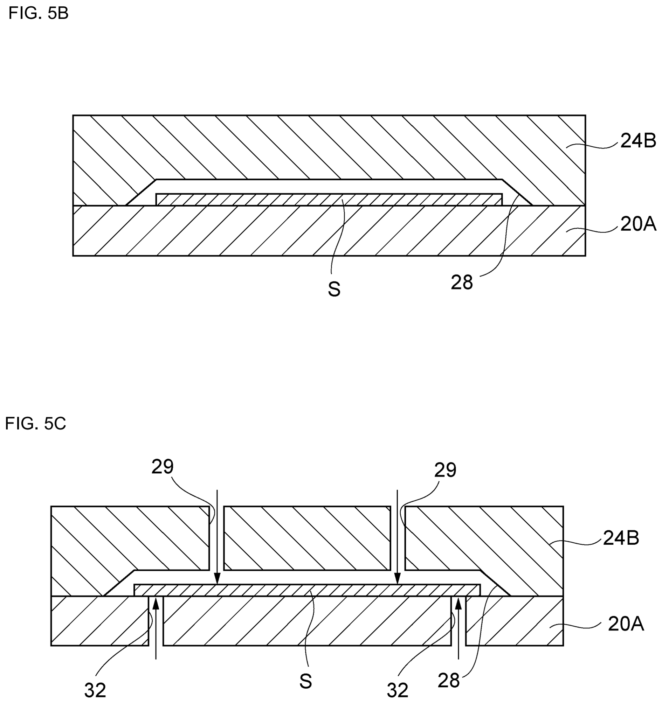

Next, as depicted in Fig. 5B, the first substrate 20A and the movable portion 24B are joined by direct bonding in a state in which position adjustment between the etching stopper layer S formed on the first substrate 20A and the recessed portion 28 formed in the movable portion 24B has been executed.

Next, as depicted in Fig. 5C, the movable portion 24B and the first substrate 20A are etched by reactive ion etching (RIE) to positions at which the etching stopper layer S is formed, and the slits 29 penetrating the movable portion 24B in the thickness direction and the slits 32 penetrating the first substrate 20A in the thickness direction are formed.

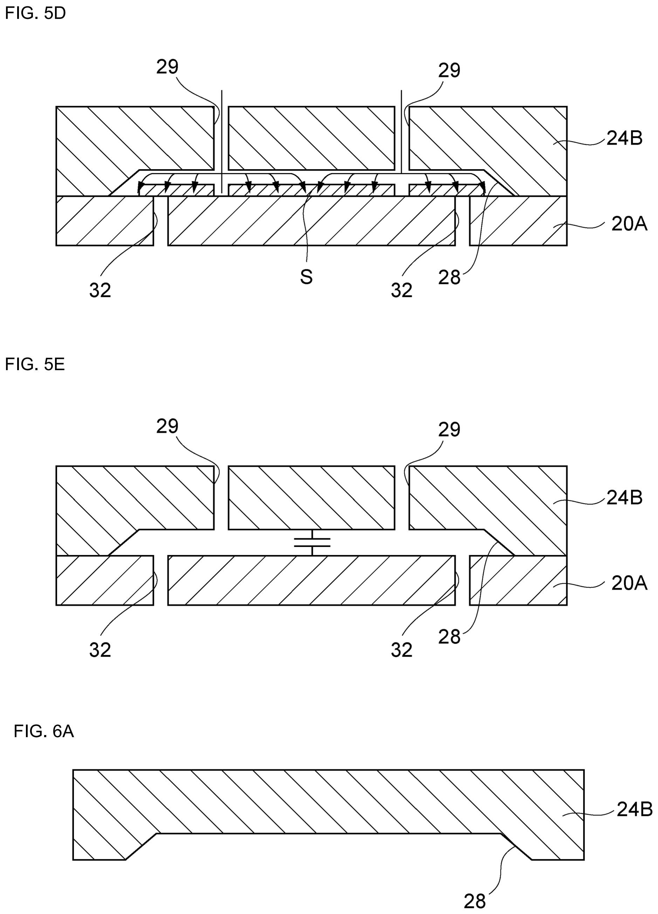

Next, as depicted in Fig. 5D, a vapor-phase hydrofluoric acid gas is supplied to a space formed between the recessed portion 28 of the movable portion 24B and the first substrate 20A through the slits 29 and 32 formed previously, and the etching stopper layer S is removed.

Through this process, as depicted in Fig. 5E, an electrostatic capacity portion with electrostatic capacity that changes depending on the distance between the movable portion 24B and the first substrate 20A is formed in the space between the movable portion 24B and the first substrate 20A.

Next, a description is given below of another example of the manufacturing method for the MEMS device 1, particularly of another example of the method for forming electrostatic capacity between the movable portion 24B and the first substrate 20A.

First, as depicted in Fig. 6A, the recessed portion 28 is formed by the LOCOS method in the surface opposite to the first substrate 20A in the movable portion 24B.

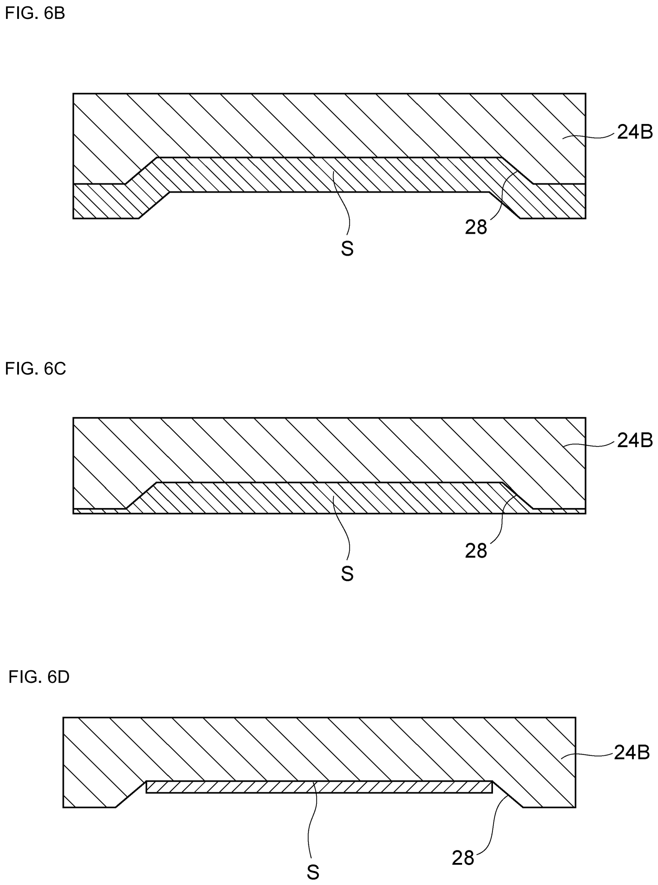

Next, as depicted in Fig. 6B, the surface opposite to the first substrate 20A in the movable portion 24B is coated with the etching stopper layer S formed of a silicon oxide film.

Next, as depicted in Fig. 6C, the etching stopper layer S is planarized.

Next, as depicted in Fig. 6D, the etching stopper layer S is formed on the bottom surface of the recessed portion 28 of the movable portion 24B by etching the planarized etching stopper layer S.

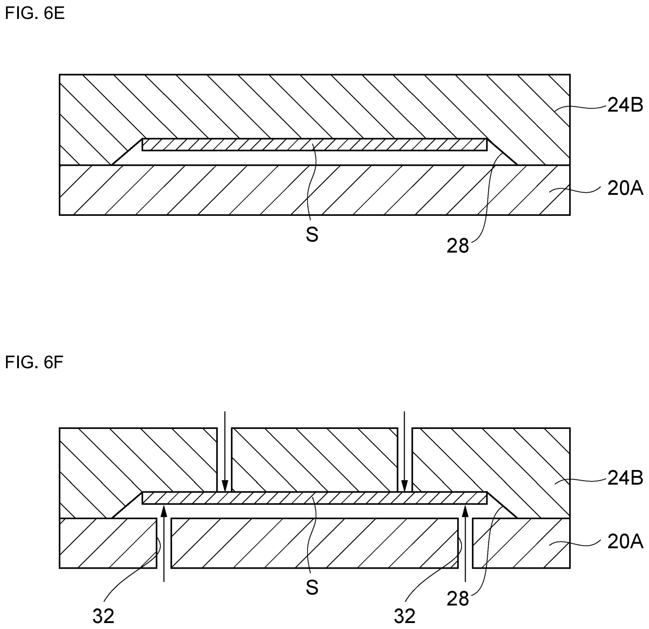

Next, as depicted in Fig. 6E, the movable portion 24B on which the etching stopper layer S is formed and the first substrate 20A are joined by direct bonding.

Next, as depicted in Fig. 6F, the movable portion 24B and the first substrate 20A are etched by reactive ion etching (RIE) to positions at which the etching stopper layer S is formed, and the slits 29 penetrating the movable portion 24B in the thickness direction and the slits 32 penetrating the first substrate 20A in the thickness direction are formed.

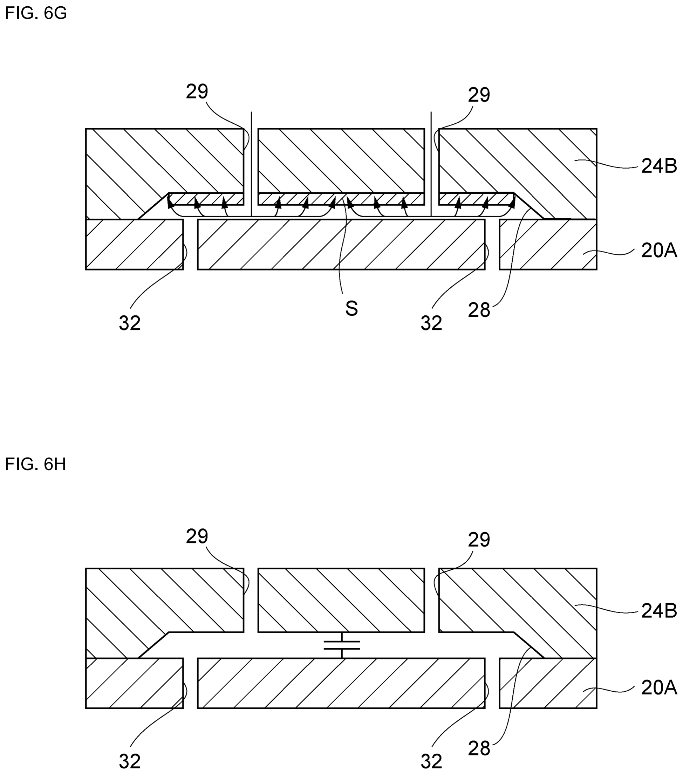

Next, as depicted in Fig. 6G, a vapor-phase hydrofluoric acid gas is supplied to a space formed between the recessed portion 31 of the movable portion 24B and the first substrate 20A through the slits 29 and 32 formed previously, and the etching stopper layer S is removed.

Through this process, as depicted in Fig. 6H, an electrostatic capacity portion with electrostatic capacity that changes depending on the distance between the movable portion 24B and the first substrate 20A is formed in the space between the movable portion 24B and the first substrate 20A.

As described above, in the MEMS device 1 of the present embodiment, when the movable portion 24B is displaced, with the part joined to the second substrate 20B in the first substrate 20A being the origin, the electrostatic capacity changes depending on the distance between the movable portion 24B and the first substrate 20A, and the electrostatic capacity changes depending on the distance between the movable portion 24B and the upper cover 30. Further, an inertial force or a pressure acting on the MEMS device 1 is determined by sensing these changes in the electrostatic capacity. In this case, in the MEMS device 1 of the present embodiment, the first substrate 20A and the second substrate 20B are joined by the direct bonding.
Thus, differently from a case in which a silicon oxide film is interposed between the first substrate 20A and the second substrate 20B, it is not required to make a via electrode and execute side etching treatment, and contribution to size reduction of the MEMS device 1 is enabled.

Further, in the MEMS device 1 of the present embodiment, the surface opposite to the first substrate 20A in the movable portion 24B is provided with the protruding portion 27 with a protrusion amount smaller than the interval between the movable portion 24B and the first substrate 20A. This suppresses the occurrence of a situation in which the movable portion 24B sticks to the first substrate 20A and the displacement of the movable portion 24B is inhibited when the movable portion 24B has approached the first substrate 20A to such a position as to come into contact with the first substrate 20A.

Moreover, in the MEMS device 1 of the present embodiment, the thickness of the second substrate 20B is thicker than that of the first substrate 20A. This facilitates ensuring of the amount of movement of the MEMS device 1 in the Z-axis direction in a case in which the MEMS device 1 receives an inertial force (for example, acceleration or angular velocity) or a pressure in the Z-axis direction, and can contribute to improvement in the detection accuracy of the MEMS device 1.

Further, in the manufacturing method for the MEMS device 1 according to the present embodiment, after the recessed portion 28 is formed in the movable portion 24B and the etching stopper layer S is formed in the recessed portion 28, the first substrate 20A and the second substrate 20B are etched to positions at which the etching stopper layer S is formed. Then, the etching stopper layer S is removed by using a vapor-phase hydrofluoric acid gas or a hydrofluoric acid. Thus, differently from a case in which the recessed portion 28 is not formed in the movable portion 24B, it is not required to make innumerable slits in the movable portion 24B for the purpose of removing the etching stopper layer S, and contribution to size reduction of the MEMS device 1 is enabled.

Moreover, in the manufacturing method for the MEMS device 1 according to the present embodiment, the recessed portion 28 is formed in the movable portion 24B by the LOCOS method. Thus, the depth of the recessed portion 28 can be controlled with high accuracy, and the electrostatic capacity formed between the movable portion 24B and the first substrate 20A can be set to an appropriate value.

Further, in the manufacturing method for the MEMS device 1 according to the present embodiment, the etching stopper layer S is formed in the recessed portion 28 of the movable portion 24B, and then the movable portion 24B on which the etching stopper layer is formed is joined to the first substrate 20A by the direct bonding. Thus, it is not required to execute position adjustment between the etching stopper layer S and the recessed portion 28 of the movable portion 24B, and contribution to further size reduction of the MEMS device 1 is enabled.

It is also possible to carry out the above-described embodiment with the following forms.

In the above-described embodiment, the thickness of the second substrate 20B may be equivalent to that of the first substrate 20A, or may be thinner than that of the first substrate 20A.

In the above-described embodiment, the description has been given by taking as an example the configuration in which the surface opposite to the first substrate 20A in the second substrate 20B is provided with the protruding portion 27 with a protrusion amount smaller than the interval between the first substrate 20A and the second substrate 20B. However, instead of or in addition to this, the surface opposite to the second substrate 20B in the first substrate 20A may be provided with a protruding portion with a protrusion amount smaller than the interval between the first substrate 20A and the second substrate 20B.

In the above-described embodiment, moreover, the surface opposite to the upper cover 30 in the second substrate 20B may be provided with a protruding portion with a protrusion amount smaller than the interval between the upper cover 30 and the second substrate 20B.

In the above-described embodiment, the description has been given by taking as an example the configuration in which the surface opposite to the first substrate 20A in the second substrate 20B has the recessed portion 28 and the electrostatic capacity portion is made in the recessed portion 28. Instead of or in addition to this, the surface opposite to the second substrate 20B in the first substrate 20A may have a recessed portion, and an electrostatic capacity portion may be made in the recessed portion.

In the above-described embodiment, moreover, at least one of the surface opposite to the second substrate 20B in the upper cover 30 or the surface opposite to the upper cover 30 in the second substrate 20B may have a recessed portion, and an electrostatic capacity portion may be made in the recessed portion.

Supplementary notes are given below concerning part or all of embodiments of the present invention. The present invention is not limited to the following supplementary notes.

<1> A MEMS device comprising:
   a lower cover;
   an upper cover that forms a space between the upper cover and the lower cover;
   a first substrate that is disposed opposite to the lower cover in the space formed between the upper cover and the lower cover and is composed of single-crystal silicon;
   a second substrate that is disposed opposite to the upper cover in the space formed between the upper cover and the lower cover and is composed of single-crystal silicon, the second substrate including a movable portion, the single-crystal silicon of the second substrate being joined to the single-crystal silicon of the first substrate; and
   an electrostatic capacity portion that is made at least one of between the upper cover and the second substrate or between the first substrate and the second substrate and is configured such that electrostatic capacity changes depending on a distance between the movable portion and the upper cover or the first substrate.
<2> The MEMS device according to <1>, wherein
   at least one of a surface opposite to the second substrate in the upper cover or a surface opposite to the upper cover in the second substrate has a first recessed portion, and
   the electrostatic capacity portion is made in the first recessed portion.
<3> The MEMS device according to <1> or <2>, wherein
   at least one of a surface opposite to the second substrate in the first substrate or a surface opposite to the first substrate in the second substrate has a second recessed portion, and
   the electrostatic capacity portion is made in the second recessed portion.
<4> The MEMS device according to any one of <1> to <3>, wherein
   a surface opposite to the upper cover in the second substrate has a protruding portion with a protrusion amount smaller than an interval between the upper cover and the second substrate.
<5> The MEMS device according to any one of <1> to <4>, wherein
   at least one of a surface opposite to the first substrate in the second substrate or a surface opposite to the second substrate in the first substrate has a protruding portion with a protrusion amount smaller than an interval between the first substrate and the second substrate.
<6> The MEMS device according to any one of <1> to <5>, wherein
   a thickness of the second substrate is thicker than a thickness of the first substrate.
<7> A manufacturing method for a MEMS device, the manufacturing method comprising:
   a step of disposing a first substrate composed of single-crystal silicon opposite to a lower cover;
   a step of disposing a second substrate that is composed of single-crystal silicon and includes a movable portion opposite to an upper cover and joining the single-crystal silicon of the second substrate to the single-crystal silicon of the first substrate;
   a step of disposing the first substrate and the second substrate in a space surrounded by the upper cover and the lower cover; and
   a step of making an electrostatic capacity portion at least one of between the upper cover and the second substrate or between the first substrate and the second substrate, the electrostatic capacity portion being configured such that electrostatic capacity changes depending on a distance between the movable portion and the upper cover or the first substrate.
<8> The manufacturing method for the MEMS device according to <7>, further comprising:
   a step of forming, by thermal oxidation treatment, a protruding portion with a protrusion amount smaller than an interval between the upper cover and the second substrate on a surface opposite to the upper cover in the second substrate.
<9> The manufacturing method for the MEMS device according to <7> or <8>, further comprising:
   a step of forming, by thermal oxidation treatment, a protruding portion with a protrusion amount smaller than an interval between the first substrate and the second substrate on at least one of a surface opposite to the first substrate in the second substrate or a surface opposite to the second substrate in the first substrate.
<10> The manufacturing method for the MEMS device according to any one of <7> to <9>, further comprising:
   a step of forming, by thermal oxidation treatment, a recessed portion in at least one of a surface opposite to the second substrate in the first substrate or a surface opposite to the first substrate in the second substrate;
   a step of forming an etching stopper layer in the recessed portion; and
   a step of etching the first substrate and the second substrate to a position at which the etching stopper layer is formed.
<11> The manufacturing method for the MEMS device according to <10>, further comprising:
   a step of removing the etching stopper layer by using a vapor-phase hydrofluoric acid gas or a hydrofluoric acid after the first substrate and the second substrate are etched.
<12> The manufacturing method for the MEMS device according to <10> or <11>, wherein
   the step of forming the etching stopper layer includes
   a step of coating the surface in which the recessed portion is formed in the first substrate or the second substrate with a silicon oxide film,
   a step of planarizing the silicon oxide film, and
   a step of etching the planarized silicon oxide film.

As described above, according to a mode of the present invention, a MEMS device and a manufacturing method for a MEMS device that enable size reduction can be provided.

The respective embodiments described above are those for facilitating understanding of the present invention, and are not those for interpreting the present invention in a limited manner. The present invention can be changed/modified without departing from the gist thereof, and equivalent thereof is also included in the present invention. That is, a configuration obtained by adding a design change to each embodiment as appropriate by those skilled in the art is also included in the scope of the present invention as long as the configuration has a feature of the present invention. For example, each element included in each embodiment and the arrangement, material, condition, shape, size, and the like thereof are not limited to those shown as examples, and can be changed as appropriate. Further, it is obvious that the respective embodiments have been given as examples and partial replacement or combination of configurations shown in different embodiments is possible, and configurations obtained by the partial replacement or combination are also included in the scope of the present invention as long as the configurations include a feature of the present invention.

### Reference Signs List

- 1: MEMS device
- 10: lower cover
- 20: device layer
- 20A: first substrate
- 20B: second substrate
- 24B: movable portion
- 27: protruding portion
- 28: recessed portion
- 30: upper cover
- S: etching stopper layer

## Claims

1. A MEMS device comprising:
a lower cover;
an upper cover that forms a space between the upper cover and the lower cover;
a first substrate that is disposed opposite to the lower cover in the space formed between the upper cover and the lower cover and is composed of single-crystal silicon;
a second substrate that is disposed opposite to the upper cover in the space formed between the upper cover and the lower cover and is composed of single-crystal silicon, the second substrate including a movable portion, the single-crystal silicon of the second substrate being joined to the single-crystal silicon of the first substrate; and
an electrostatic capacity portion that is made at least one of between the upper cover and the second substrate or between the first substrate and the second substrate and is configured such that electrostatic capacity changes depending on a distance between the movable portion and the upper cover or the first substrate.

2. The MEMS device according to claim 1, wherein
at least one of a surface opposite to the second substrate in the upper cover or a surface opposite to the upper cover in the second substrate has a first recessed portion, and
the electrostatic capacity portion is made in the first recessed portion.

3. The MEMS device according to claim 1 or 2, wherein
at least one of a surface opposite to the second substrate in the first substrate or a surface opposite to the first substrate in the second substrate has a second recessed portion, and
the electrostatic capacity portion is made in the second recessed portion.

4. The MEMS device according to any one of claims 1 to 3, wherein
a surface opposite to the upper cover in the second substrate has a protruding portion with a protrusion amount smaller than an interval between the upper cover and the second substrate.

5. The MEMS device according to any one of claims 1 to 4, wherein
at least one of a surface opposite to the first substrate in the second substrate or a surface opposite to the second substrate in the first substrate has a protruding portion with a protrusion amount smaller than an interval between the first substrate and the second substrate.

6. The MEMS device according to any one of claims 1 to 5, wherein
a thickness of the second substrate is thicker than a thickness of the first substrate.

7. A manufacturing method for a MEMS device, the manufacturing method comprising:
a step of disposing a first substrate composed of single-crystal silicon opposite to a lower cover;
a step of disposing a second substrate that is composed of single-crystal silicon and includes a movable portion opposite to an upper cover and joining the single-crystal silicon of the second substrate to the single-crystal silicon of the first substrate;
a step of disposing the first substrate and the second substrate in a space surrounded by the upper cover and the lower cover; and
a step of making an electrostatic capacity portion at least one of between the upper cover and the second substrate or between the first substrate and the second substrate, the electrostatic capacity portion being configured such that electrostatic capacity changes depending on a distance between the movable portion and the upper cover or the first substrate.

8. The manufacturing method for the MEMS device according to claim 7, further comprising:
a step of forming, by thermal oxidation treatment, a protruding portion with a protrusion amount smaller than an interval between the upper cover and the second substrate on a surface opposite to the upper cover in the second substrate.

9. The manufacturing method for the MEMS device according to claim 7 or 8, further comprising:
a step of forming, by thermal oxidation treatment, a protruding portion with a protrusion amount smaller than an interval between the first substrate and the second substrate on at least one of a surface opposite to the first substrate in the second substrate or a surface opposite to the second substrate in the first substrate.

10. The manufacturing method for the MEMS device according to any one of claims 7 to 9, further comprising:
a step of forming, by thermal oxidation treatment, a recessed portion in at least one of a surface opposite to the second substrate in the first substrate or a surface opposite to the first substrate in the second substrate;
a step of forming an etching stopper layer in the recessed portion; and
a step of etching the first substrate and the second substrate to a position at which the etching stopper layer is formed.

11. The manufacturing method for the MEMS device according to claim 10, further comprising:
a step of removing the etching stopper layer by using a vapor-phase hydrofluoric acid gas or a hydrofluoric acid after the first substrate and the second substrate are etched.

12. The manufacturing method for the MEMS device according to claim 10 or 11, wherein
the step of forming the etching stopper layer includes
a step of coating the surface in which the recessed portion is formed in the first substrate or the second substrate with a silicon oxide film,
a step of planarizing the silicon oxide film, and
a step of etching the planarized silicon oxide film.
